# EUROPÄISCHE PATENTSCHRIFT

(11) **EP 1 225 255 B1**
(45) Veröffentlichungstag und Bekanntmachung des Hinweises auf die Patenterteilung: **24.11.2004**
(21) Anmeldenummer: 02000204.4
(22) Anmeldetag: 10.01.2002
(51) Int. Cl.: C30B 15/30, C30B 15/00, C30B 29/06

(54) **Verfahren und Vorrichtung zum Herstellen eines Einkristalls aus Silicium**
Process and apparatus for producing silicon single crystal
Procédé et appareillage pour la production des monocristaux de silicium

(30) Priorität: 18.01.2001 DE 10102126
(43) Veröffentlichungstag der Anmeldung: 24.07.2002
(73) Patentinhaber: Siltronic AG, 81737 München (DE)
(72) Erfinder: von Ammon, Wilfried, Dr., 5122 Hochburg/Ach (AT); Virbulis, Janis, Dr., 84489 Burghausen (DE); Tomzig, Erich, Dr., 84508 Burgkirchen (DE); Gelfgat, Yuri, Dr., 2010 Jurmala (LV); Gorbunov, Leonid, Dr., 1063 Riga (LV)
(74) Vertreter: Rimböck, Karl-Heinz, Dr.

(56) Entgegenhaltungen:
- DE-A- 3 701 733
- DE-A- 19 935 184
- US-A- 5 196 085
- US-A- 6 001 170
- GIESS E A ET AL: "COMBINATION HEATER-MAGNETIC SOLENOID COIL(S) FOR SUPPRESSING MELT CONVECTION IN CRYSTAL GROWTH" IBM TECHNICAL DISCLOSURE BULLETIN, IBM CORP. NEW YORK, US, Bd. 26, Nr. 9, 1. Februar 1984 (1984-02-01), Seite 4716 XP002054780 ISSN: 0018-8689
- PATENT ABSTRACTS OF JAPAN vol. 010, no. 139 (C-348), 22. Mai 1986 (1986-05-22) & JP 60 264391 A (NIPPON DENKI KK), 27. Dezember 1985 (1985-12-27)

## Beschreibung

Gegenstand der Erfindung ist ein Verfahren zum Herstellen eines Einkristalls aus Silicium, durch Ziehen des Einkristalls aus einer Schmelze, die in einem Tiegel enthalten ist und dem Einfluß eines magnetischen Wanderfelds ausgesetzt wird. Gegenstand der Erfindung ist auch eine Vorrichtung, die geeignet ist, das Verfahren auszuführen.

In der DE-37 01 733 A1 ist ein Verfahren der genannten Art beschrieben. Der Einsatz des magnetischen Wanderfelds dient dem Zweck, den Einbau von Sauerstoff in den Einkristall zu verringern.

Die vorliegende Erfindung verfolgt demgegenüber andere und teilweise gegensätzliche Ziele. Sie betrifft ein Verfahren zum Ziehen von Einkristallen aus Silicium, die einen Durchmesser von mindestens 200 mm besitzen, insbesondere solche der modernsten Generation mit Durchmessern von 300 mm und darüber. Die Herstellung solcher Kristalle erfordert, daß eine Reihe von Problemen überwunden werden. Die Verbesserung der Ausbeute durch Verringern der Versetzungshäufigkeit ist eine der zentralen Aufgaben. Eine andere betrifft die Ziehgeschwindigkeit, die aus Gründen der Produktivität möglichst hoch sein soll, andererseits jedoch nicht beliebig gesteigert werden kann, weil der Einkristall nicht bei jeder Geschwindigkeit in der gewünschten zylindrischer Form wachsen kann. Eine weitere Aufgabe besteht darin, die Erwartungen von Herstellern elektronischer Bauelemente erfüllen zu können, die die Konzentration von Sauerstoff im Einkristall in einem weiten Bereich vorgeben möchten. Das verlangt vom Hersteller des Einkristalls, daß er in der Lage muß, vergleichsweise hohe Konzentrationen an Sauerstoff im Einkristall zu gewährleisten, wenn wegen der vorteilhaften Getterwirkung des Sauerstoffs solche Konzentrationen nachgefragt werden.

Gegenstand der vorliegenden Erfindung ist ein Verfahren zum Herstellen eines Einkristalls aus Silicium, durch Ziehen des Einkristalls aus einer Schmelze, die in einem Tiegel mit einem Durchmesser von mindestens 450 mm enthalten ist, über dem ein Wärmeschild angeordnet ist, wobei der Einkristall mit einem Durchmesser von mindestens 200 mm gezogen wird und die Schmelze dem Einfluß eines magnetischen Wanderfelds ausgesetzt wird, das im Bereich der Tiegelwand eine im wesentlichen vertikal ausgerichtete Kraft auf die Schmelze ausübt.

Gegenstand der Erfindung ist weiterhin eine Vorrichtung zum Ziehen eines Einkristalls aus Silicium, umfassend einen Tiegel mit einem Durchmesser von mindestens 450 mm, eine im Tiegel enthaltene Schmelze, eine um den Tiegel herum angeordnete Heizeinrichtung, einen über dem Tiegel angeordneten Hitzeschild und eine Einrichtung zum Erzeugen eines magnetischen Wanderfelds, das im Bereich der Tiegelwand eine im wesentlichen vertikal ausgerichtete Kraft auf die Schmelze ausübt.

Wie die Erfinder festgestellt haben, können mit Hilfe der Erfindung Ausbeuteverbesserungen erzielt, Steigerungen der Ziehgeschwindigkeit vorgenommen, die Sauerstoffkonzentration im Einkristall erhöht und die Position eines OSF-Ringes bei vorgegebener Ziehgeschwindigkeit nach außen verlagert werden. Ein OSF-Ring ist ein ringförmiger Bereich einer aus dem Einkristall herausgetrennten Halbleiterscheibe aus Silicium, der als Grenze gilt, die zwei Defekttypen, nämlich Zwischengitterdefekte und Leerstellendefekte, voneinander trennt. Es ist vorteilhaft, wenn sich der OSF-Ring am Rand der Halbleiterscheibe befindet, weil diese dann nur noch von einem der beiden Defekttypen dominiert wird.

Das Verfahren hat einen weiteren Vorteil, der beim Impflingsziehen zum Tragen kommt, also in der Anfangsphase des Kristallziehens, während der ein Impfkristall mit der Schmelze in Kontakt gebracht und mit dem Kristallwachstum begonnen wird. Hierbei ist die Gefahr der Versetzungsbildung besonders groß. Es hat sich gezeigt, daß das magnetische Wanderfeld die Versetzungshäufigkeit reduziert. Darüber hinaus ist das magnetische Wanderfeld auch beim Aufschmelzen von Silicium und beim Stabilisieren der Schmelze vor dem Impflingsziehen nützlich, da beide Vorgänge beschleunigt durchgeführt werden können. Gründe dafür sind eine bessere Durchmischung der Schmelze und geringere Temperaturfluktuationen in der Schmelze.

Überraschenderweise tritt der in der DE-37 01 733 A1 beschriebene Effekt der Sauerstoffverringerung beim Ausführen der Erfindung gemäß einer ersten Ausbildungsform nicht auf. Vermutlich liegt das daran, daß beim Ziehen eines Einkristalls gemäß der DE-37 01 733 A1 die nach oben gerichtete thermische Konvektion durch Anlegen eines magnetischen Wanderfelds mit Kraftrichtung nach unten abgebremst wird. Die Konsequenz ist, daß die für den Sauerstofftransport und den Einbau von Sauerstoff in den Einkristall ursächliche Strömungsgeschwindigkeit durch den Einfluß des Magnetfelds verlangsamt wird, und deshalb eine größere Menge an Sauerstoff in Form von SiO über die Schmelzenoberfläche entweichen kann und entsprechend weniger Sauerstoff in den Einkristall eingebaut wird. Im Gegensatz dazu spielt bei der Erfindung nicht die Strömungsgeschwindigkeit, sondern vielmehr die Strömungsrichtung die entscheidende Rolle. Die Strömungsrichtung ist beim Ziehen eines Einkristalls mit einem Durchmesser von mindestens 200 mm aus einem Tiegel mit einem Durchmesser von mindestens 450 mm beim Anlegen eines magnetischen Wanderfelds mit Kraftrichtung nach unten (erste Ausbildungsform der Erfindung) nicht mehr nach oben, zur Oberfläche der Schmelze gerichtet. Es bildet sich vielmehr eine Konvektion aus, die zunächst zum Tiegelboden hin und später zum wachsenden Einkristall hin gerichtet ist. Dadurch wird Sauerstoff mit einer nahezu gleichbleibend hohen Rate in den wachsenden Einkristall eingebaut, obwohl ein Tiegel verwendet wird, der das Ausdampfen von SiO aus der Schmelze fördert, weil er eine vergleichsweise große freie Schmelzenoberfläche ermöglicht, obwohl ein Hitzeschild verwendet wird, der das Ausdampfen von SiO aus der Schmelze fördert, weil er die Temperatur der Schmelzenoberfläche erhöht und obwohl ein Gasstrom zur Schmelzenoberfläche geführt werden kann, der das Ausdampfen von SiO aus der Schmelze fördert, weil er das austretende SiO ständig abtransportiert. Entsprechend wird auch gefunden, daß der Einbau von Sauerstoff in den Einkristall verringert werden kann, wenn die Kraftwirkung des magnetischen Wanderfelds im Bereich der Tiegelwand nach oben gerichtet ist (zweite Ausbildungsform der Erfindung).

Die Erfindung wird nachfolgend mit Hilfe von Figuren näher beschrieben. Bei Fig.1 handelt es sich um die schematische Schnittdarstellung einer besonders bevorzugten Vorrichtung zum Ziehen eines Einkristalls. Fig.2 zeigt ein Diagramm, bei dem die Amplitude niederfrequenter Temperaturfluktuationen in der Schmelze gegen die Intensität des an die Schmelze gelegten, magnetischen Wanderfelds aufgetragen ist. Fig.3 zeigt eine Betrachtung der Sauerstoffkonzentration im gezogenen Einkristall in Abhängigkeit der Position des Einkristalls in Längsrichtung bei vier Einkristallen, die erfindungsgemäß, aber nach verschiedenen Varianten der Erfindung gezogen wurden. Fig.4 zeigt den Radius des OSF-Ringes in Abhängigkeit der Ziehgeschwindigkeit bis zu einer maximal möglichen Ziehgeschwindigkeit, wobei das Verfahren gemäß der Erfindung mit bisher üblichen Verfahren verglichen wird.

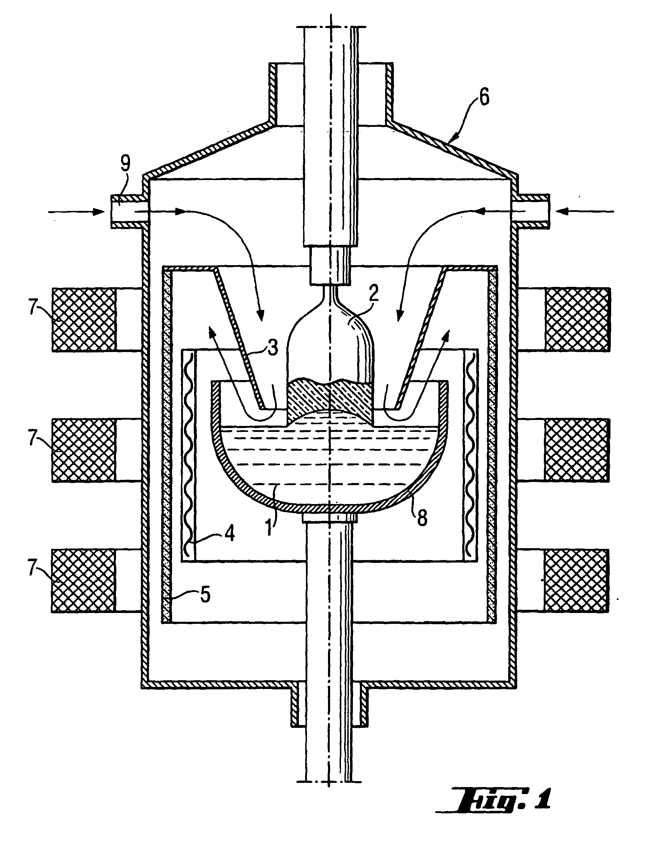

Die Vorrichtung gemäß Fig.1 umfaßt einen Rezipienten 6, in dem ein Tiegel 8, eine Einrichtung 4 zum Beheizen des Tiegels und eine Isolierung 5 untergebracht sind. Die Isolierung schirmt die Wand des Rezipienten gegen die Strahlungswärme der Heizeinrichtung 4 ab und bildet ein Lager für einen Hitzeschild 3, der über dem Tiegel angeordnet ist. Der Hitzeschild schirmt den wachsenden Einkristall 2, der aus einer im Tiegel enthaltenen Schmelze 1 gezogen wird, thermisch ab und dient auch als Führungsbegrenzung für einen von einer Einrichtung 9 zugeführten Gasstrom, der zur Oberfläche der Schmelze gerichtet ist und von der Schmelze ausdampfendes Siliciumoxid aus dem Bereich über dem Tiegel fortspült. Es kommen insbesondere Inertgase wie beispielsweise Argon oder Stickstoff und Mischungen solcher Gase in Frage, wobei auch Wasserstoff als Bestandteil des Gasstroms anwesend sein kann. Der Tiegel besitzt einen Durchmesser von mindestens 450 mm und erzeugt somit eine vergleichsweise große freie Schmelzenoberfläche.

Um den Rezipienten 6 herum sind zwei oder mehrere Spulen einer magnetischen Einrichtung 7 angeordnet, die mit elektrischem Wechselstrom versorgt werden, so daß die Schmelze im Tiegel unter den Einfluß eines magnetischen Wanderfelds gerät. Die Wand des Rezipienten muß mindestens im Bereich zwischen der magnetischen Einrichtung und der Schmelze für das Magnetfeld durchlässig sein. Dies kann gewährleistet werden, indem die Frequenz des Feldes niedrig gewählt wird oder die Wand des Rezipienten aus elektrisch schlecht leitendem Material, beispielsweise Quarz oder Keramik, ausgebildet ist. Die Anordnung der magnetischen Einrichtung außerhalb des Rezipienten ist zwar aus Platzgründen bevorzugt, jedoch nicht zwingend notwendig. Die magnetische Einrichtung kann daher auch zwischen dem Tiegel und der Heizeinrichtung angeordnet sein und es besteht außerdem noch die Möglichkeit, die Heizeinrichtung beispielsweise als spiralförmigen Mehrphaseninduktor auszubilden, der die Funktion der magnetischen Einrichtung zusätzlich erfüllt, so daß eine separate magnetische Einrichtung nicht benötigt wird.

Gemäß einer bevorzugten Ausführungsform der Erfindung umfaßt die magnetische Einrichtung 7 drei Spulen, die an eine 3-Phasen Stromversorgung angeschlossen sind. Die Spulen können sowohl in Stern- als auch in Dreieckschaltung angeschlossen sein. Durch eine entsprechende Wahl der Reihenfolge der Anschlussleitungen wird magnetisches Wanderfeld erzeugt, das im Bereich der Tiegelwand eine nach unten oder eine nach oben gerichtete Kraft auf die Schmelze ausübt. Die Anschlüsse der Spulen haben zweckmäßigerweise eine Phasenlage mit der Reihenfolge 0°-60°-120° oder 0°-120°-240°, wobei die letztere bevorzugt ist. Die vom Magnetfeld in der Schmelze hervorgerufene Kraft ist im Bereich der Tiegelwand beispielsweise nach unten, zum Boden des Tiegels gerichtet (erste Ausbildungsform der Erfindung), wenn die untere Spule mit 0°-Phase, die mittlere Spule mit 120°-Phase und die obere Spule mit 240°-Phase angeschlossen ist. Die Kraft ist nach oben gerichtet (zweite Ausbildungsform der Erfindung), wenn die Phasenlage der unteren und der oberen Spule vertauscht ist. Die Windungszahl der Spulen beträgt typischerweise 20 bis 40 Windungen je Spule und ist vorzugsweise bei allen oder bei mindestens zwei der verwendeten Spulen die selbe. Die Intensität des an die Schmelze angelegten Magnetfelds beträgt vorzugsweise 1 bis 15 mT, entsprechend einer Zahl von ungefähr 800 bis 12000 Amperewindungen.

Wie das nachfolgende Beispiel 2 belegt, ist bei einer nach unten gerichteten Kraftwirkung des Magnetfelds der Einbau von Sauerstoff in den Einkristall erhöht. Ist die vom Magnetfeld hervorgerufene Kraft entgegengesetzt, also nach oben gerichtet, so ist der Einbau von Sauerstoff geringer. In beiden Fällen jedoch führt der Einfluß des magnetischen Wanderfelds zu einer Ausbeuteverbesserung, die ihren Grund in einer Dämpfung niederfrequenter Temperaturfluktuationen hat, obwohl solche Fluktuationen in Tiegeln mit Durchmessern von mindestens 450 mm besonders ausgeprägt sind und durch die Verwendung eines Hitzeschilds noch verstärkt werden. Dies ist ein überraschendes Ergebnis, zumal die Konvektion in der Schmelze beim Anlegen eines magnetischen Wanderfelds mit der Intensität des Magnetfelds zunimmt und Geschwindigkeitsfluktuationen stärker werden. Offensichtlich sind jedoch gerade die niederfrequenten Temperaturfluktuationen für Versetzungen verantwortlich, die die Ausbeute erniedrigen.

### Beispiel 1:

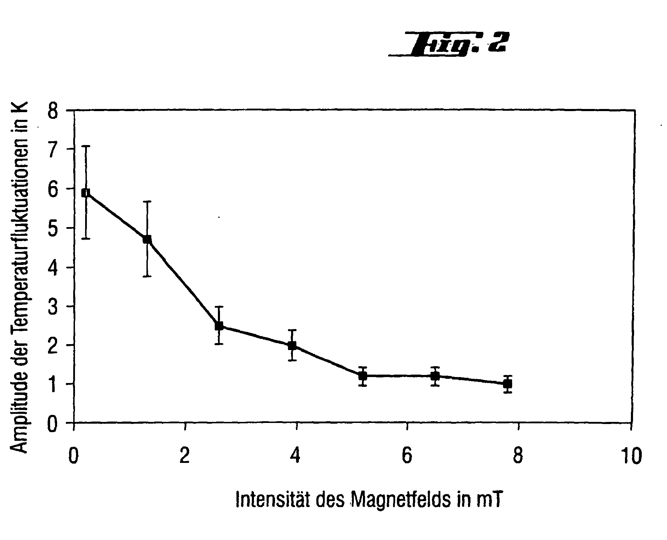

Es wurde eine Vorrichtung gemäß Fig.1 mit drei Spulen mit 36, 40 und 36 Windungen verwendet, die mit 0°-120°-240° Phasenlage angeschlossen waren. Die Temperatur der Schmelze wurde mit eingetauchten Thermoelementen gemessen. Der verwendete Tiegel hatte einen Durchmesser von 35.5 cm (14'') und enthielt 20 kg Silicium. Fig.2 zeigt, wie niederfrequente Temperaturfluktuationen in der Schmelze mit steigender Intensität des Magnetfelds abnehmen. Eine Intensität von 6 mT entspricht einer Stromstärke von 81 A.

### Beispiel 2:

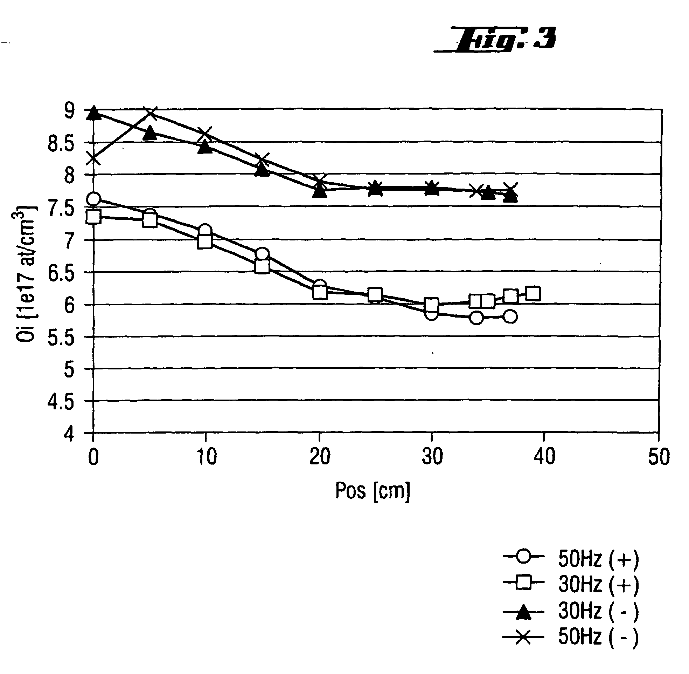

Es wurde eine Vorrichtung gemäß Fig.1 mit drei Spulen mit jeweils 20 Windungen eingesetzt. Die Stromstärken betrugen 350 A in jeder Spule, entsprechend einer Zahl von 7000 Amperewindungen. Der verwendete Quarztiegel hatte einen Durchmesser von 60,9 cm (24'') und enthielt ausreichend Silicium, um einen Einkristall mit einem Durchmesser von 300 mm ziehen zu können. Es wurden vier Einkristalle unter nahezu gleichen Bedingungen gezogen. Unterschiedlich waren nur die Frequenz und die Richtung der Wanderungsbewegung des Magnetfelds. Fig.3 macht deutlich, daß der Einbau von Sauerstoff in den Einkristall deutlich höher ist, wenn die vom Magnetfeld hervorgerufene Kraft nach unten gerichtet ist. Hingegen wirkt sich eine Frequenzänderung nur geringfügig auf die Sauerstoffkonzentration im Einkristall aus.

### Beispiel 3:

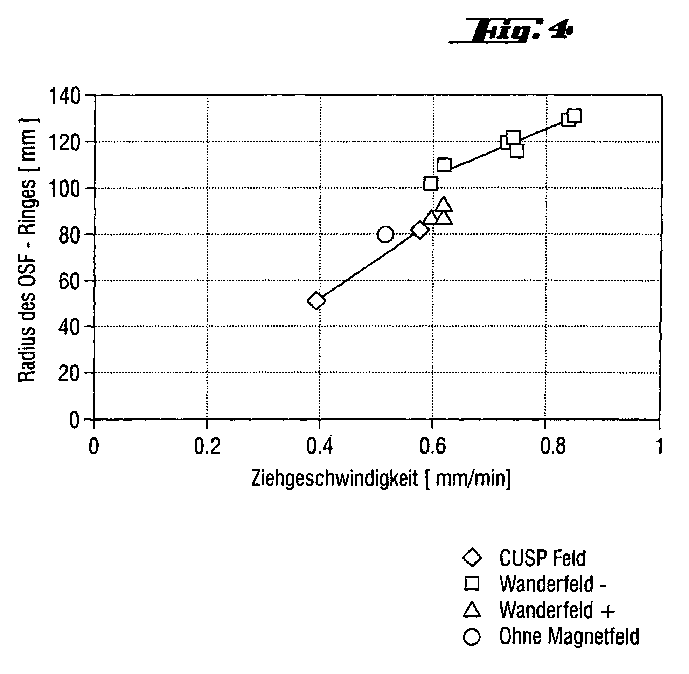

Es wurden mehrere Einkristalle mit einem Durchmesser von 300 mm unter verschiedenen Bedingungen und mit unterschiedlichen Ziehgeschwindigkeiten gezogen, wobei die Ziehgeschwindigkeiten bis zu einer Geschwindigkeit gewählt wurden, die gerade noch das Ziehen eines Einkristalls mit der gewünschten runden Form ermöglichten. Es wurden vier grundsätzlich unterschiedliche Ziehbedingungen untersucht, und zwar übliche Bedingungen ohne Anwendung eines Magnetfelds, Bedingungen, bei denen die Schmelze unter dem Einfluß eines statischen, sogenannten CUSP-Feldes stand und erfindungsgemäße Bedingungen mit wanderndem Magnetfeld mit nach unten (-) oder nach oben (+) gerichteter Kraft. Für Versuche, die unter erfindungsgemäßen Bedingungen erfolgten, wurde eine Vorrichtung gemäß Fig.1 mit einem Spulensystem gemäß Beispiel 2 eingesetzt. Der verwendete Tiegel hatte in allen Fällen einen Durchmesser von 71.1 cm (28''). Fig.4 zeigt, daß die höchsten Ziehgeschwindigkeiten mit dem erfindungsgemäßen Verfahren zu erreichen sind, wobei es am vorteilhaftesten ist, wenn das magnetische Wanderfeld eine nach unten gerichtete Kraft auf die Schmelze ausübt. Ebenso wird unter diesen Bedingungen die Lage des OSF-Rings am stärksten nach außen gedrängt.

## Patentansprüche

1. Verfahren zum Herstellen eines Einkristalls aus Silicium, durch Ziehen des Einkristalls aus einer Schmelze, die in einem Tiegel mit einem Durchmesser von mindestens 450 mm enthalten ist, über dem ein Wärmeschild angeordnet ist, wobei der Einkristall mit einem Durchmesser von mindestens 200 mm gezogen wird und die Schmelze dem Einfluss eines magnetischen Wanderfelds ausgesetzt wird, das im Bereich der Tiegelwand eine im wesentlichen vertikal ausgerichtete Kraft auf die Schmelze ausübt und das magnetischen Wanderfeld der einzige Magnetfeldtyp ist, dem die Schmelze ausgesetzt wird.

2. Verfahren nach Anspruch 1, **dadurch gekennzeichnet, daß** der Einkristall mit einer Konzentration an Sauerstoff von mindestens 5 * 10¹⁷ Atome pro cm³ gezogen wird.

3. Verfahren nach Anspruch 1, **dadurch gekennzeichnet, daß** das magnetische Wanderfeld eine an der Tiegelwand hauptsächlich nach unten gerichtete Kraft auf die Schmelze ausübt.

4. Verfahren nach Anspruch 1, **dadurch gekennzeichnet, daß** das magnetische Wanderfeld eine an der Tiegelwand hauptsächlich nach oben gerichtete Kraft auf die Schmelze ausübt.

5. Vorrichtung zum Ziehen eines Einkristalls aus Silicium, umfassend einen Tiegel mit einem Durchmesser von mindestens 450 mm, eine im Tiegel enthaltene Schmelze, eine um den Tiegel herum angeordnete Heizeinrichtung, einen über dem Tiegel angeordneten Hitzeschild und eine Einrichtung zum Erzeugen eines magnetischen Wanderfelds, das im Bereich der Tiegelwand eine im wesentlichen vertikal ausgerichtete Kraft auf die Schmelze ausübt.

6. Vorrichtung nach Anspruch 5, **dadurch gekennzeichnet, daß** die das magnetische Wanderfeld erzeugende Einrichtung um den Tiegel herum angeordnet ist und weiter zum Tiegel beabstandet ist, als die Heizeinrichtung.

7. Vorrichtung nach Anspruch 5, **dadurch gekennzeichnet, daß** die das magnetische Wanderfeld erzeugende Einrichtung um den Tiegel herum angeordnet ist und näher zum Tiegel beabstandet ist, als die Heizeinrichtung.

8. Vorrichtung nach einem der Ansprüche 5 bis 7, **dadurch gekennzeichnet, daß** die Einrichtung zum Erzeugen des magnetischen Wänderfelds mindestens zwei Spulen umfaßt.

9. Vorrichtung nach Anspruch 5, mit einer um den Tiegel herum angeordneten Heizeinrichtung, die als spriralförmiger Mehrphaseninduktor ausgebildet ist und das magnetische Wanderfeld erzeugt.

## Claims

1. Process for producing a silicon single crystal, by pulling the single crystal from a melt which is contained in a crucible with a diameter of at least 450 mm, above which a heat shield is arranged, the single crystal being pulled with a diameter of at least 200 mm and the melt being exposed to the influence of a travelling magnetic field which exerts a substantially vertically oriented force on the melt in the region of the crucible wall, and the travelling magnetic field being the only type of magnetic field to which the melt is exposed.

2. Process according to Claim 1, **characterized in that** the single crystal is pulled with an oxygen concentration of at least 5 * 10¹⁷ atoms per cm³.

3. Process according to Claim 1, **characterized in that** the travelling magnetic field exerts a force which is primarily directed downwards at the crucible wall on the melt.

4. Process according to Claim 1, **characterized in that** the travelling magnetic field exerts a force which is primarily directed upwards at the crucible wall on the melt.

5. Apparatus for pulling a silicon single crystal, comprising a crucible with a diameter of at least 450 mm, a melt which is contained in the crucible, a heater device arranged around the crucible, a heat shield arranged above the crucible and a device for generating a travelling magnetic field which, in the region of the crucible wall, exerts a substantially vertically oriented force on the melt.

6. Apparatus according to Claim 5, **characterized in that** the device which generates the travelling magnetic field is arranged around the crucible and is further away from the crucible than the heater device.

7. Apparatus according to Claim 5, **characterized in that** the device which generates the travelling magnetic field is arranged around the crucible and is closer to the crucible than the heater device.

8. Apparatus according to one of Claims 5 to 7, **characterized in that** the device for generating the travelling magnetic field comprises at least two coils.

9. Apparatus according to Claim 5, having a heater device arranged around the crucible, which is designed as a helical multiphase inductor and generates the travelling magnetic field.

## Revendications

1. Procédé de fabrication d'un monocristal de silicium par extraction du monocristal hors d'un bain de fusion contenu dans un creuset d'un diamètre d'au moins 450 mm au-dessus duquel est disposé un écran thermique, le monocristal étant extrait à un diamètre d'au moins 200 mm et le bain de fusion subissant l'effet d'un champ magnétique progressif qui, dans la région de la paroi du creuset, exerce sur le bain de fusion une force orientée essentiellement à la verticale et le champ magnétique progressif auquel le bain de fusion est exposé étant du type à champ magnétique unique.

2. Procédé selon la revendication 1, **caractérisé en ce que** le monocristal est extrait à une concentration en oxygène d'au moins 5 * 10¹⁷ atomes par cm³.

3. Procédé selon la revendication 1, **caractérisé en ce que** le champ magnétique progressif exerce sur le bain de fusion une force dirigée essentiellement vers le bas sur la paroi du creuset.

4. Procédé selon la revendication 1, **caractérisé en ce que** le champ magnétique progressif exerce sur le bain de fusion une force dirigée essentiellement vers le haut sur la paroi du creuset.

5. Dispositif d'extraction d'un monocristal de silicium, qui comprend un creuset d'un diamètre d'au moins 450 mm, un bain de fusion contenu dans le creuset, un dispositif de chauffage disposé autour du creuset, un écran thermique disposé au-dessus du creuset et un dispositif de création d'un champ magnétique progressif qui, dans la zone de la paroi du creuset, exerce sur le bain de fusion une force orientée essentiellement à la verticale.

6. Dispositif selon la revendication 5, **caractérisé en ce que** le dispositif qui crée un champ magnétique progressif est disposé autour du creuset à une distance plus grande que le dispositif de chauffage.

7. Dispositif selon la revendication 5, **caractérisé en ce que** le dispositif qui crée un champ magnétique progressif est disposé autour du creuset à une distance plus petite que le dispositif de chauffage.

8. Dispositif selon l'une des revendications 5 à 7, **caractérisé en ce que** le dispositif qui crée un champ magnétique progressif comporte au moins deux bobines.

9. Dispositif selon la revendication 5, doté d'un dispositif de chauffage qui est disposé autour du creuset, qui est configuré comme inducteur polyphasé en spirale et qui crée le champ magnétique progressif.
